(19) Europäisches Patentamt
European Patent Office
Office européen des brevets

(11) Veröffentlichungsnummer: **0 319 777 B1**

(12) # EUROPÄISCHE PATENTSCHRIFT

(45) Veröffentlichungstag der Patentschrift: **17.08.94**

(51) Int. Cl.5: **H03G 3/32**

(21) Anmeldenummer: **88119519.2**

(22) Anmeldetag: **24.11.88**

(54) **Verfahren und Schaltungsanordnung zur selbsttätigen störgeräuschabhängigen Lautstärkeregelung.**

(30) Priorität: **05.12.87 DE 3741253**

(43) Veröffentlichungstag der Anmeldung:
**14.06.89 Patentblatt 89/24**

(45) Bekanntmachung des Hinweises auf die Patenterteilung:
**17.08.94 Patentblatt 94/33**

(84) Benannte Vertragsstaaten:
**DE FR GB SE**

(56) Entgegenhaltungen:
**EP-A- 0 119 645**
**EP-A- 0 179 530**
**DE-A- 2 456 468**
**DE-A- 2 836 371**

**ELECTRONICS, Band 45, Nr. 24, November 1972, Seiten 118-121, New York, US; D.B.HOISINGTON et al.: "Automatic control of speaker output compensates for noisy-background"**

(73) Patentinhaber: **Blaupunkt-Werke GmbH**
**Postfach 77 77 77,**
**Robert-Bosch-Strasse 200**
**D-31132 Hildesheim (DE)**

(72) Erfinder: **Barschdorff, Dieter, Prof. Dr.**
**Alfener-Weg 1**
**D-4790 Paderborn (DE)**
Erfinder: **Wetzlar, Dietmar, Dr.**
**Oeynhausener-Weg 15**
**D-4790 Paderborn (DE)**
Erfinder: **Klöckner, Ralf**
**Erlenweg 12**
**D-5439 Niederrossbach (DE)**

(74) Vertreter: **Friedmann, Jürgen, Dr.-Ing.**
**c/o Robert Bosch GmbH,**
**Postfach 30 02 20**
**D-70442 Stuttgart (DE)**

EP 0 319 777 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren und eine Schaltungsanordnung nach der Gattung des Hauptanspruchs.

Die selbsttätige störgeräuschabhängige Lautstärkeregelung ist insbesondere in Kraftfahrzeugen vorteilhaft, da dort die Störgeräusche einem ständigen Wechsel unterworfen sind.

Das Störgeräusch in einem Kraftfahrzeug hängt unter anderem ab: von der Fahrgeschwindigkeit, dem Karosserieaufbau und der Innenausstattung des Fahrzeugs sowie der Besetzung des Fahrzeugs mit Fahrgästen wie auch von der Belüftung des Fahrgastraumes durch gegebenenfalls geöffnete Fenster oder durch einen laufenden Ventilator. Jede Änderung dieser Einflußgrößen weckt den Wunsch in dem Hörer, den Lautstärkeregler für das akustische Nutzsignal zu betätigen, sei es um die Wiedergabe lauter oder leiser zu stellen. Nicht immer hat der Autofahrer eine Hand frei, den Regler zu verstellen, oder die Fahrsituation erlaubt es ihm nicht. Häufig wechselt auch die Lautstärke des Störgeräusches zu rasch, um ihr mit der Reglerbetätigung zu folgen.

Bei bekannten Verfahren zur selbsttätigen Lautstärkeregelung in Fahrzeugen wird die Stellgröße für den Lautstärkeregler entweder aus der Fahrgeschwindigkeit oder aus der Motordrehzahl abgeleitet.

Aus der EP 0179 530 ist ein Verfahren zur selbsttätigen störgeräuschabhängigen Lautstärkeregelung bekannt, wobei die Amplitude von Nutzsignalen, welche mindestens einem Lautsprecher zugeführt und in Nutzschall umgewandelt werden, geregelt wird und wobei mit Hilfe mindestens eines Mikrofons, welches dem Nutzschall und dem Störgeräusch ausgesetzt ist, aus diesen ein Summensignal erzeugt wird. Bei diesem bekannten Verfahren werden die Hüllkurven des Nutzsignals und des Summensignals gebildet und einander überlagert und aus dem Überlagerungssignal ein Stellsignal für die Lautstärkeregelung abgeleitet. Eine entsprechende Lehre ist auch der Zeitschrift Electronics/20.11.1972/Seite 118 bis 121 zu entnehmen.

Der Erfindung lag die Aufgabe zugrunde, ein Verfahren zu finden, welches eine Berücksichtigung der jeweiligen tatsächlichen Übertragungsstrecke zwischen Lautsprecher und Mikrofon bei der störgeräuschabhängigen Lautstärkeregelung gestattet. Diese Aufgabe wird durch die Merkmale des Verfahrens nach dem Hauptanspruch gelöst.

Durch die in den Unteransprüchen aufgeführten Maßnahmen sind vorteilhafte Weiterbildungen und Verbesserungen der im Hauptanspruch angegebenen Erfindung und Schaltungsanordnungen zur Durchführung des erfindungsgemäßen Verfahrens gekennzeichnet.

Ausführungsbeispiele der Erfindung sind in der Zeichnung anhand mehrerer Figuren dargestellt und in der nachfolgenden Beschreibung näher erläutert. Es zeigt:

- Fig. 1 eine Schaltungsanordnung zur Durchführung des erfindungsgemäßen Verfahrens,
- Fig. 2 eine Schaltungsanordnung, bei der eine Extraktion des Störgeräuschsignals aus dem Summensignal über das gesamte vom Nutzsignal erfaßte Frequenzband erfolgt,
- Fig. 3 eine Schaltungsanordnung, bei der das Nutzsignal und das Summensignal jeweils in mehrere Frequenzbereiche aufgeteilt werden,
- Fig. 4 eine gegenüber der Schaltungsanordnung nach Fig. 3 erweiterte Schaltungsanordnung,
- Fig. 5 eine Schaltungsanordnung, bei welcher die Frequenzbandaufspaltung ebenfalls vom Signalprozessor vorgenommen wird, und
- Fig. 6 ein Flußdiagramm des Programms zur Darstellung eines adaptiven Digitalfilters.

Gleiche Teile sind in den Figuren mit gleichen Bezugszeichen versehen.

Bei der Schaltungsanordnung nach Fig. 1 wird das Ausgangssignal einer Nutzsignalquelle 1 über einen steuerbaren Verstärker (Lautstärkeregler) 2 einem Lautsprecher 3 zugeführt. Die Nutzsignalquelle kann beispielsweise der Empfangsteil eines Autoradios oder eines Funkgerätes oder eine Wiedergabeeinrichtung für aufgezeichnete Tonereignisse sein. Das Nutzsignal x(t) wird im Lautsprecher 3 in Nutzschall g(t) umgewandelt. Der steuerbare Verstärker 2 wird von einem Stellsignal gesteuert, das in der im folgenden beschriebenen Weise erzeugt wird:

Im Abstrahlungsbereich des Lautsprechers 3 sowie im Einwirkungsbereich des Störgeräusches ist ein Mikrofon 5 angeordnet, dessen Ausgangssignal der Summe des Störgeräusches n(t) und des Nutzschalls g(t) entspricht. Dieses Signal d(t) - im folgenden Summensignal genannt - wird nach Verstärkung in einem Verstärker 15 in einer Schaltung 6 von dem Anteil befreit, welcher dem Nutzschall möglichst weitgehend entspricht, so daß ein Signal verbleibt, welches das Störgeräusch umso genauer wiedergibt, umso besser die Nachbildung der Übertragungsstrecke erfolgt. Dieses Signal wird im folgenden Störgeräuschsignal genannt.

Wegen der digitalen Signalverarbeitung in der Schaltung 6 wird das Summensignal d(t) der Schaltung 6 über einen Analog/Digital-Wandler 7 zugeführt, dem in an sich bekannter Weise zur Vermeidung von Alias-Störungen ein Tiefpaß 8 vorgeschaltet ist. In entsprechender Weise wird das Nutzsignal ebenfalls über einen Tiefpaß 9 und einen Analog/Digital-Wandler 10 der Schaltung 6 zugeführt, während das Störgeräuschsignal s(t) der Schaltung 6 über einen Digital/Analog-Wandler 11 und einen Tiefpaß 12 entnehmbar ist.

Die Schaltung 6 enthält im wesentlichen ein adaptives Digitalfilter 13 und eine Subtrahierschaltung 14. Das adaptive Digitalfilter 13 stellt eine Nachbildung der Übertragungsstrecke dar, welche aus dem Lautsprecher, dem akustischen System zwischen dem Lautsprecher 3 und dem Mikrofon 5 und gegebenenfalls dem Mikrofon 5 besteht. Zur Realisierung der Schaltung 6 stehen geeignete Signalprozessoren zur Verfügung, beispielsweise mit der Typenbezeichnung TMS 32020 der Firma Texas Instruments.

Dabei wird das adaptive Digitalfilter 13 derart adaptiert, daß es die Eigenschaften dieser Übertragungsstrecke mit der für die Zwecke der Regelung erforderlichen Genauigkeit auch bei einer Änderung der Eigenschaften der Übertragungsstrecke aufweist. Das Ausgangssignal des adaptiven Digitalfilters 13 wird der Subtrahierschaltung 14 zugeführt und somit vom Summensignal subtrahiert, so daß lediglich ein dem Störgeräusch entsprechendes Störgeräuschsignal übrigbleibt.

Aus dem Störgeräuschsignal wird in einer Bewertungsschaltung 4 ein Stellsignal z(t) gewonnen, welches einem Steuereingang des steuerbaren Verstärkers 2 zugeführt wird. Vorzugsweise erfolgt die Bewertung durch Bildung des Effektivwertes des Störgrößensignals, wobei eine schnelle Regelung der Lautstärke durch relativ kleine Zeitkonstanten bei der Effektivwert-Bildung erreicht wird.

Bei stereofoner Wiedergabe ist zur Aufnahme des Summensignals ein Mikrofon ausreichend. Je nach den Erfordernissen im einzelnen können dabei eine oder zwei Nachbildungen vorgesehen sein.

Bei der Auslegung des adaptiven Digitalfilters 13 wird der sogenannte LMS-Algorithmus mit globaler suboptimaler Schrittgröße $\eta$ und exponentieller Mittelung durchgeführt, dabei bedeutet LMS least-mean-square. Der LMS-Algorithmus nach B. Widrow ist ein Gradientenverfahren, das die Leistung des Ausgangssignals s(t) minimiert.

Die Vorschrift für die Berechnung der Filterkoeffizienten lautet:

$$c_k(n+1) = c_k(n) + \eta * s(n) * x(n-k)$$

mit $c_k$ = k-ter Koeffizient des Transversalfilters. Die Schrittgröße $\eta$ kann dabei konstant oder variabel sein. Die variable Schrittgröße ist abhängig von der momentanen Leistung des Eingangssignals x(t):

$$\eta(n) = \frac{\mu}{f^2(n)}, \qquad 0<\mu<2$$

$$f^2(n) = \zeta\, f^2(n-1) + (1-\zeta)\,[x_T(n)x(n)] \quad 0<\zeta<1$$

Da die Schrittgröße $\eta$ (n) nach jeder Abtastung für alle Koeffizienten $c_O$ bis $c_M$ gleich ist, spricht man hier von globaler Schrittgröße.

Als Ordnung des Transversalfilters hat sich 100 bei der versuchsweisen Durchführung des erfindungsgemäßen Verfahrens als brauchbar erwiesen.

Bei der in Fig. 2 dargestellten Schaltungsanordnung werden Störgeräuschsignale für drei Frequenzbereiche des Störgeräusches ermittelt. Die Mittenfrequenzen dieser Frequenzbereiche liegen vorzugsweise bei 100 Hz, 700 Hz und 4,4 KHz. Dabei erfolgt eine Extraktion des Störgeräuschsignals aus dem Summensignal breitbandig mit Hilfe eines gemeinsamen Signalprozessors 6. Dem Digital/Analog-Wandler 11 sind jedoch drei Bandpässe 16, 17, 18 nachgeschaltet, von deren Ausgängen jeweils ein Störgeräuschsignal $s_1(t)$, $s_2(t)$ und $s_3(t)$ über je eine Bewertungsschaltung 19, 20, 21 je einem steuerbaren Verstärker 25, 26, 27 als Stellsignal $z_1(t)$, $z_2(t)$ bzw. $z_3(t)$ zugeführt wird. Die steuerbaren Verstärker sind für je einen Frequenzbereich der Audiosignale vorgesehen. Entsprechend wird das Nutzsignal mit Hilfe von drei Bandpässen 22, 23, 24 aufgespalten und in einer Addierschaltung 28 wieder zusammengefaßt, von der es über eine Endstufe 29 zum Lautsprecher 3 gelangt. Die Steuerung der Lautstärke mit den Störgeräuschsignalen $s_1(t)$, $s_2(t)$ und $s_3(t)$ kann auch mit Hilfe einer Schaltung erfolgen, die im wesentlichen auf ein vorgegebenes Pegelverhältnis zwischen Nutzschall und Störgeräusch abhebt, entsprechend der Patentanmeldung P 37 30 763.0 der Anmelderin.

Während bei der Schaltungsanordnung nach Fig. 2 davon ausgegangen wird, daß eine einzige Nachbildung der Übertragungsstrecke zwischen Lautsprecher und Mikrofon innerhalb des gesamten Audiobereiches genügend genau den tatsächlichen akustischen Verhältnissen im Fahrgastraum entspricht, ist bei der Schaltungsanordnung nach Fig. 3 für jeweils einen der Frequenzbereiche eine Nachbildung vorgesehen, welcher einerseits die in dem entsprechenden Frequenzbereich auftretenden Komponenten des Nutzsignals x(t) und andererseits die jeweils im gleichen Frequenzbereich liegenden Komponenten des Summensignals d(t) zugeführt werden. Dabei werden gemäß Fig. 3 die Nachbildungen von einem einzigen Signalprozessor realisiert, der die Signale aus den verschiedenen Frequenzbereichen sequentiell verarbeitet. Im Rahmen der Erfindung ist es jedoch auch möglich, drei getrennte Signalprozessoren zu verwenden.

Zur Aufspaltung des Frequenzbandes der Signale x(t) und d(t) dienen die Bandpässe 31 bis 36, wobei jeweils die Bandpässe 31 und 34, 32 und 35 und 33 und 36 gleiche Durchlaßbereiche aufweisen. Die Ausgangssignale der Bandpässe 31 bis 36 werden mit Hilfe von Mischstufen 41 bis 46, denen jeweils ein entsprechender Träger zugeführt wird, in einen niedrigeren Frequenzbereich transformiert. Dadurch wird eine niedrigere Abtastfrequenz bei der Analog/Digital-Wandlung und bei der anschließenden Signalverabeitung ermöglicht.

Über Tiefpässe 51 bis 56 und Analog/Digital-Wandler 61 bis 66 werden die einzelnen Signale dann dem Signalprozessor 67 zugeführt. Nach dem Multiplexverfahren wird jeweils ein Abtastwert jeweils einer der Komponenten der Signale x(t) und d(t) verarbeitet und ein Abtastwert der entsprechenden Komponente $s_1$-(t), $s_2$(t) bzw. $s_3$(t) des Störgeräuschssignals s(t) über jeweils einen Digital/Analog-Wandler 71 bis 73 und einen Tiefpaß 74 bis 76 je einer Mischstufe 77 bis 79 zugeführt, mit deren Hilfe die Signale in den ursprünglichen Frequenzbereich umgesetzt werden. Anschließende Bandpässe 81 bis 83 leiten nur diejenigen Mischprodukte weiter, welche in dem vorgegebenen Frequenzbereich liegen. An den Ausgängen 84, 85, 86 stehen dann die Komponenten $s_1$(t), $s_2$(t) und $s_3$(t) des Störgeräuschsignals s(t) zur Verfügung.

Bei der Schaltungsanordnung nach Fig. 4 erfolgt die Aufbereitung des zugeführten Summensignals d(t) und des Nutzsignals x(t) in gleicher Weise wie bei der Schaltungsanordnung nach Fig. 3. Gegenüber der Schaltungsanordnung nach Fig. 3 ist jedoch der Signalprozessor 90 einerseits etwas detaillierterer dargestellt und andererseits bezüglich seiner Funktion erweitert. Die vom Signalprozessor dargestellten adaptiven Digitalfilter 91, 92, 93 und die Subtrahierschaltungen 94, 95, 96 sind in Fig. 4 jeweils einzeln dargestellt.

Plötzliche Änderungen der Übertragungsstrecke zwischen Lautsprecher und Mikrofon, beispielsweise durch Bewegung der Fahrgäste oder Öffnen von Fenstern, haben einen Einschwingvorgang des Algorithmus zur Folge. Auch plötzliche Pegeländerungen des Nutzsignals bewirken ein Einschwingen des Algorithmus bzw. der Nachbildung, was ebenfalls nicht in unendlich kurzer Zeit erfolgt.

Um zu verhindern, daß während der Einschwingzeit durch Anwendung eines falschen Algorithmus Störungen auftreten, erfolgt bei der Schaltungsanordnung nach Fig. 4 eine ständige Überwachung der Pegel des Nutzsignals x(t) und des Störgeräuschsignals s(t). Bei starken Änderungen des Pegels dieser Signale wird die Nachbildung "eingefroren", bis ein neuer eingeschwungener Algorithmus zur Verfügung steht. Dazu ist eine Pegelkontrolleinrichtung 100 vorgesehen. Da die "eingefrorene" Nachbildung zur Erzeugung des Störgeräuschsignals s(t) laufend benötigt wird, während der neue Algorithmus berechnet wird, sind hierfür zwei Filter bzw. eine sequentielle Filterung vorzusehen.

Bei der Schaltungsanordnung nach Fig. 4 wird ferner die Bildung der Kurzzeiteffektivwerte aus den Komponenten jeweils eines Frequenzbereichs des Störgeräuschsignals mit Hilfe des Signalprozessors 90 durchgeführt. Dazu sind jeweils die Funktionen 97, 98, 99 vorgesehen. Die somit entstandenen Stellsignale werden über Digital/Analog-Wandler 101, 102, 103 Ausgängen 104, 105, 106 zugeleitet, von denen sie jeweils einem Stellglied für die Lautstärke für den jeweiligen Frequenzbereich zugeleitet werden können. Da ein Konstanthalter des Effektivwertes nur für sehr kurze Zeit erfolgen kann, ist eine zeitliche Mittelung des Effektivwertes geeignet, um durch Einschwingvorgänge hervorgerufene schlechte Effektivwertschätzungen zu verbessern.

Bei den Ausführungsbeispielen nach den Figuren 3 und 4 erfolgt die Frequenzbandaufspaltung des Summensignals und des Nutzsignals außerhalb des Signalprozessors. Wie in den Figuren 3 und 4 dargestellt, können dabei Analogschaltungen verwendet werden. Auch eine Anwendung von digitalen Schaltungen ist möglich. Bei der Schaltungsanordnung nach Fig. 5 dagegen wird sowohl die Frequenzaufspaltung des Nutzsignals x(t) und des Summensignals d(t) als auch die Signalverarbeitung mit Hilfe eines Signalprozessors 110 durchgeführt. Dazu werden die Signale den Eingängen 111 und 112 zugeführt, von wo sie über je einen Tiefpaß 113, 114 und je einen Analog/Digital-Wandler 115, 116 an Eingänge des Signalprozessors 110 weitergeleitet werden. Das bereits in drei Frequenzbereiche aufgeteilte Störgeräuschsignal wird in digitaler Form vom Signalprozessor 110 an drei Digital/Analog-Wandler 117, 118, 119, denen jeweils ein Tiefpaß 120, 121, 122 nachgeschaltet ist, ausgegeben. Von den Ausgängen 123, 124, 125 sind die Komponenten des Störgeräuschsignals s1(t), s2(t) und s3(t) abnehmbar.

Fig. 6 stellt das Flußdiagramm eines Programms zur Darstellung eines adaptiven Digitalfilters dar. Nach dem Start des Programms bei 131 erfolgt eine Parametereingabe bei 132 und bei 133 eine Koeffizientenvorbelegung. Der Programmteil 134 umfaßt die Filterung und die Bildung des LMS-Algorithmus und wird jeweils nach einer Inkrementierung von n bei 135 wiederholt.

## Patentansprüche

1. Verfahren zur selbsttätigen störgeräuschabhängigen Lautstärkeregelung, bei dem die Amplitude von Nutzsignalen, welche in Lautsprechern in Nutzschall umgewandelt werden, mit Hilfe mindestens eines Mikrofones, welches dem Nutzschall und Störgeräusch zugleich ausgesetzt ist und aus diesen ein Summensignal erzeugt und geregelt wird,
dadurch gekennzeichnet,
daß dem Summensignal zur Bildung eines Stellsignals für die Lautstärkeregelung ein Signal überlagert wird, das aus dem Nutzsignal mit Hilfe einer an die jeweils vorhandene Übertragungsstrecke zwischen Lautsprechern und Mikrofon angepaßte Nachbildung abgeleitet wird, deren Anpassung aus der Auswertung der Korrelation zwischen dem Summensignal und dem Nutzsignal gewonnen wird.

2. Verfahren nach Anspruch 1,
dadurch gekennzeichnet,
daß das Nutzsignal innerhalb des gesamten übertragenen Frequenzbereiches zur Ableitung des weiteren Signals verwendet wird.

3. Verfahren nach Anspruch 1,
dadurch gekennzeichnet,
daß das Nutzsignal in mehrere Signale verschiedener Frequenzbereiche aufgeteilt wird und daß für jeden Frequenzbereich eine Ableitung eines weiteren Signals und eine Überlagerung mit dem Summensignal des betreffenden Frequenzbereichs erfolgt.

4. Schaltungsanordnung zur Durchführung des Verfahrens nach einem der Ansprüche 1 bis 3,
dadurch gekennzeichent,
daß die Nachbildung der Übertragungsstrecke von einem adaptiven Digitalfilter (13) gebildet ist.

5. Schaltungsanordnung nach Anspruch 4,
dadurch gekennzeichnet,
daß die Koeffizienten des adaptiven Digitalfilters (13) nach dem Gradientenverfahren anpaßbar sind.

6. Schaltungsanordnung nach Anspruch 4,
dadurch gekennzeichnet,
daß das adaptive Digitalfilter (13) von einem Signalprozessor (6, 67, 90) gebildet ist.

7. Schaltungsanordnung nach Anspruch 6,
dadurch gekennzeichnet,
daß das übertragene Frequenzband in mehrere Frequenzbereiche aufgeteilt ist und daß für jeden Frequenzbereich ein Signalprozessor vorgesehen ist.

8. Schaltungsanordnung nach Anspruch 6,
dadurch gekennzeichnet,
daß das übertragene Frequenzband in mehrere Frequenzbereiche aufgeteilt ist und daß ein Signalprozessor (67, 90) nach dem Zeitmultiplexverfahren für mehrere Frequenzbereiche vorgesehen ist.

9. Schaltungsanordnung nach Anspruch 8,
dadurch gekennzeichnet,
daß jeweils die Komponenten des Nutzsignals eines Frequenzbereichs in einen niedrigeren Frequenzbereich umgesetzt werden.

## Claims

1. Method for automatic volume control as a function of background noise, in which the amplitude of wanted signals, which are converted into wanted sound in loudspeakers, is controlled using at least one microphone exposed to the wanted sound and background noise simultaneously, from which it produces a summation signal, characterized in that an actuating signal for volume control is produced by superimposing on the summation signal a signal which is derived from the wanted signal, using a model which is matched to the relevant transmission path between loudspeakers and microphone, the matching of which model is obtained by evaluating the correlation between the summation signal and the wanted signal.

2. Method according to Claim 1, characterized in that the wanted signal over the full transmitted frequency range is used to derive the further signal.

3. Method according to Claim 1, characterized in that the wanted signal is split into a plurality of signals in different frequency ranges, and in that a further signal is derived for each frequency range and superimposed on the summation signal of the corresponding frequency range.

4. Circuit arrangement for carrying out the method according to one of the Claims 1 to 3, characterized in that the transmission path is formed by an adaptive digital filter (13).

5. Circuit arrangement according to Claim 4, characterized in that the coefficients of the adaptive digital filter (13) can be adapted using the gradient method.

6. Circuit arrangement according to Claim 4, characterized in that the adaptive digital filter (13) is formed by a signal processor (6, 67, 90).

7. Circuit arrangement according to Claim 6, characterized in that the transmitted frequency band is split into a plurality of frequency ranges, and in that a signal processor is provided for each frequency range.

8. Circuit arrangement according to Claim 6, characterized in that the transmitted frequency band is split into a plurality of frequency ranges, and in that one signal processor (67, 90) is provided for a plurality of frequency ranges, using the time division multiplex method.

9. Circuit arrangement according to Claim 8, characterized in that the components of the wanted signal in a frequency range are in each case converted to a lower frequency range.

**Revendications**

1. Procédé de régulation automatique de gain dépendant du bruit ambiant, selon lequel on convertit l'amplitude de signaux utiles transformés par des haut-parleurs en des sons utiles, à l'aide d'un microphone exposé en même temps aux sons utiles et aux bruits parasites, et à partir de celui-ci on crée un signal de somme que l'on règle, procédé caractérisé en ce que :
   - on combine au signal de somme pour former un signal de réglage du circuit de réglage du gain, un signal déduit du signal utile à l'aide d'une copie adaptée au chemin de transmission existant chaque fois entre les haut-parleurs et le microphone, et dont l'adaptation est assurée par l'exploitation de la corrélation entre le signal de somme et le signal utile.

2. Procédé selon la revendication 1, caractérisé en ce que le signal utile est utilisé à l'intérieur de toute la plage des fréquence transmise pour en déduire l'autre signal.

3. Procédé selon la revendication 1, caractérisé en ce que le signal utile est divisé en plusieurs signaux correspondant à plusieurs plages de fréquence et pour chacune des plages de fréquence, on copie un autre signal et on effectue une combinaison avec le signal de somme de la plage de fréquence concernée.

4. Circuit pour la mise en oeuvre du procédé selon l'une des revendications 1 à 3, caractérisé en ce que la copie du chemin de transmission est effectuée par un filtre numérique adaptatif (13).

5. Circuit selon la revendication 4, caractérisé en ce que les coefficients du filtre numérique adaptatif (13) sont adaptés selon le procédé par gradient.

**6.** Circuit selon la revendication 4, caractérisé en ce que le filtre numérique adaptatif (13) est formé par un processeur de signal (6, 67, 90).

**7.** Circuit selon la revendication 6, caractérisé en ce que la bande de fréquence transmise est subdivisée en plusieurs plages de fréquence et un processeur de signal est prévu pour chaque plage de fréquence.

**8.** Circuit selon la revendication 6, caractérisé en ce que la bande de fréquence transmise est divisée en plusieurs plages de fréquence et un processeur de signal (67, 90) travaillant selon le procédé par multiplex dans le temps est prévu pour plusieurs plages de fréquence.

**9.** Circuit selon la revendication 8, caractérisé en ce que chaque fois les composants du signal utile d'une plage de fréquences sont convertis en une plage de fréquence plus faible.

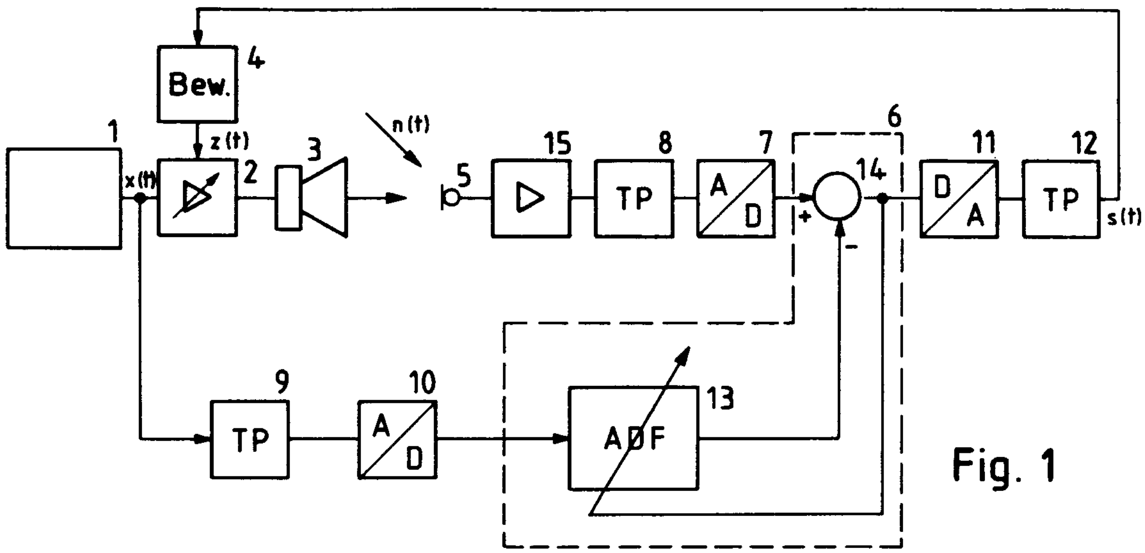

Bew.
4
1
z(t)
x(t)
2
3
n(t)
5
15
TP
8
A
D
7
6
14
+
-
D
A
11
TP
12
s(t)
9
TP
10
A
D
ADF
13


Fig. 1

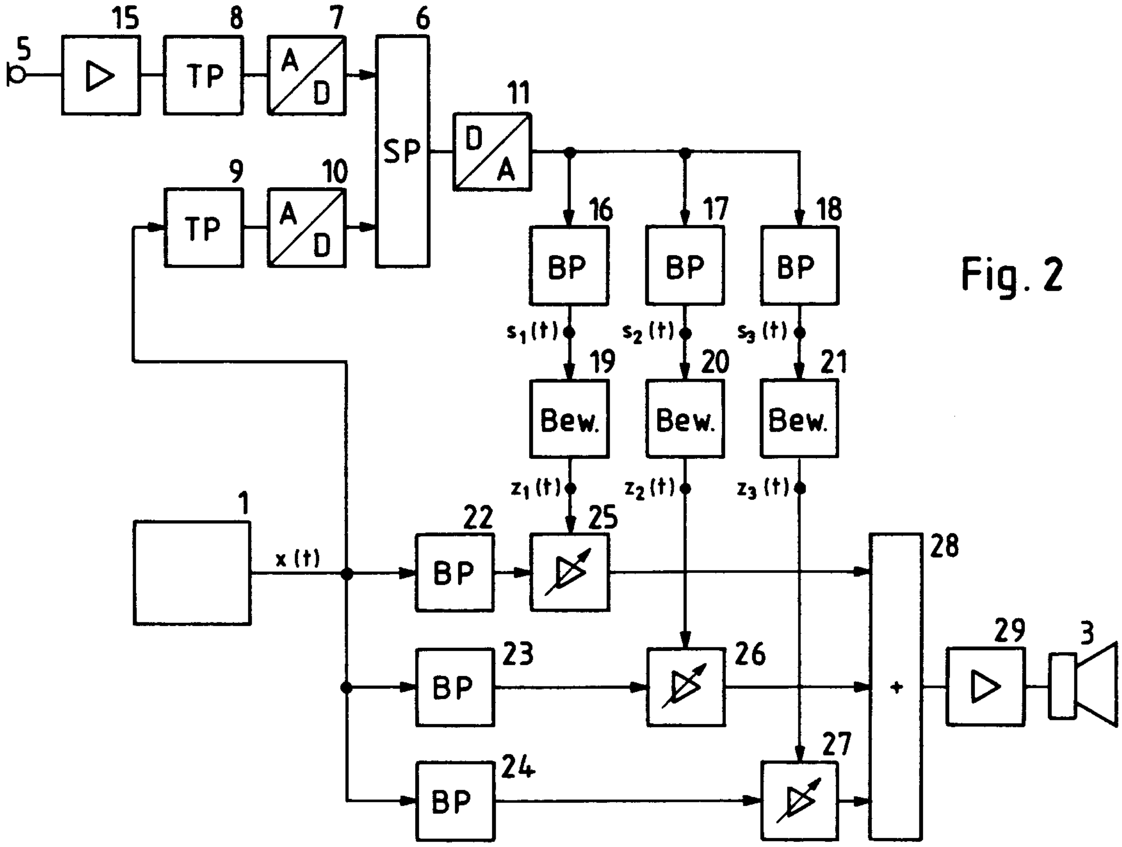

5
15
TP
8
A
D
7
6
SP
11
D
A
9
TP
10
A
D
16
BP
17
BP
18
BP
s1(t)
s2(t)
s3(t)
19
Bew.
20
Bew.
21
Bew.
z1(t)
z2(t)
z3(t)
1
x(t)
22
BP
25
23
BP
26
24
BP
27
28
+
29
3


Fig. 2

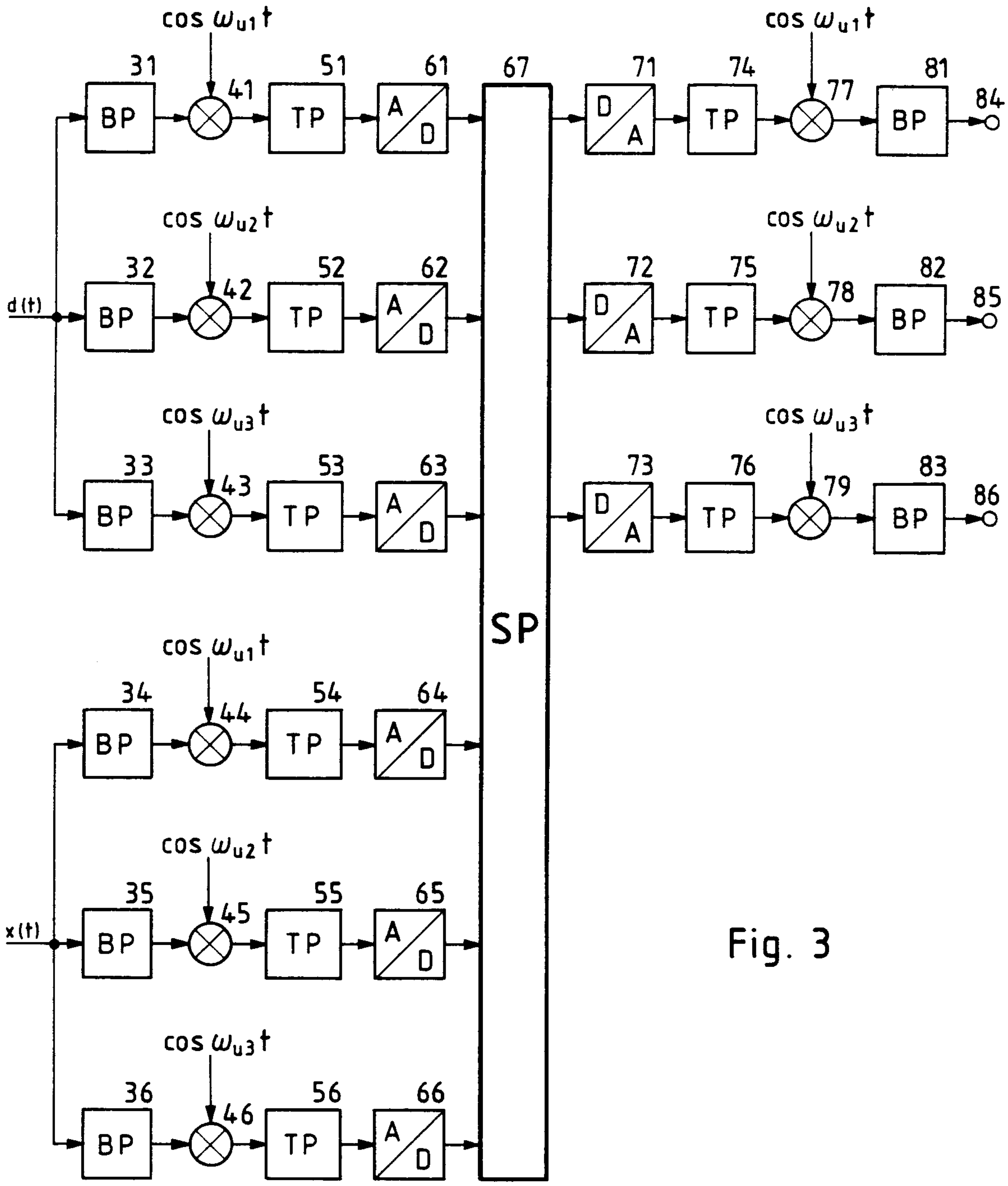
cos $\omega_{u1}t$
31
BP
41
51
TP
61
A D
67
SP
71
D A
74
TP
cos $\omega_{u1}t$
77
81
BP
84
d(t)
cos $\omega_{u2}t$
32
42
52
62
72
75
78
82
85
cos $\omega_{u3}t$
33
43
53
63
73
76
79
83
86
x(t)
34
44
54
64
35
45
55
65
36
46
56
66

Fig. 3

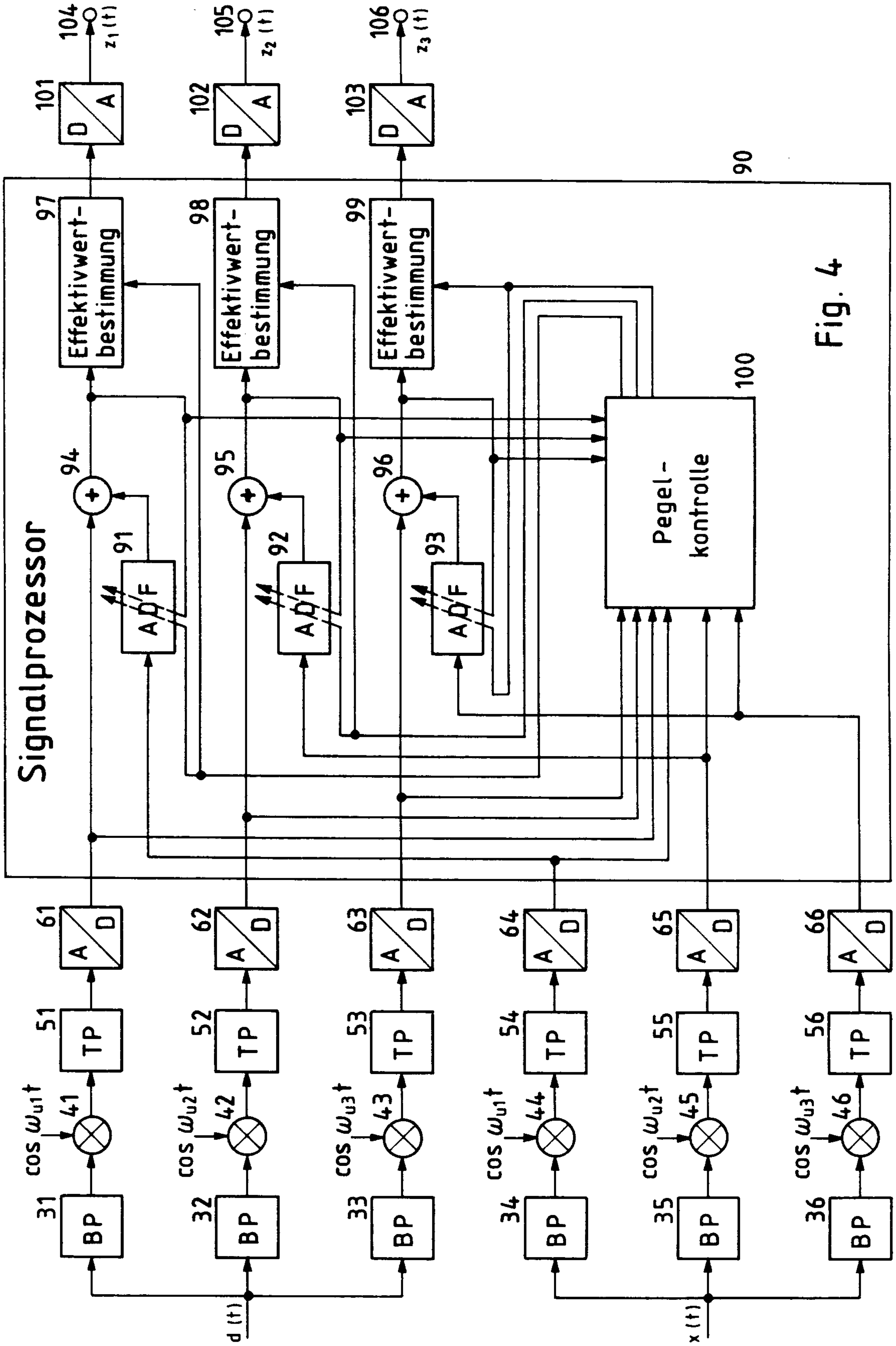

Signalprozessor
90
Effektivwert-bestimmung
97
98
99
Pegel-kontrolle
100
ADF
91
92
93
94
95
96
D A
101
102
103
104 z1(t)
105 z2(t)
106 z3(t)
A D
61
62
63
64
65
66
TP
51
52
53
54
55
56
cos ωu1t
cos ωu2t
cos ωu3t
41
42
43
44
45
46
BP
31
32
33
34
35
36
d(t)
x(t)


Fig. 4

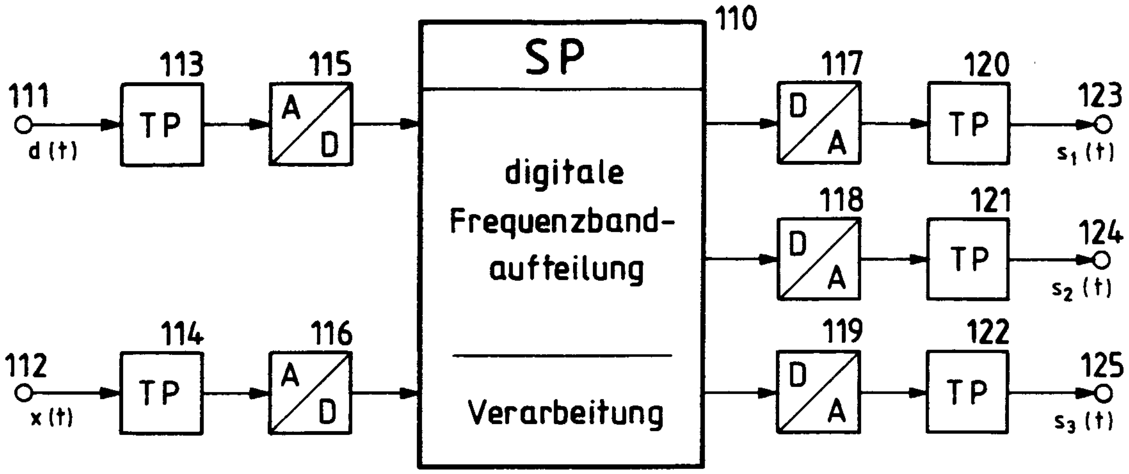
110
SP
digitale
Frequenzband-
aufteilung
Verarbeitung
111
d(t)
112
x(t)
113
TP
114
TP
115
A
D
116
A
D
117
D
A
118
D
A
119
D
A
120
TP
121
TP
122
TP
123
$s_1(t)$
124
$s_2(t)$
125
$s_3(t)$

Fig. 5

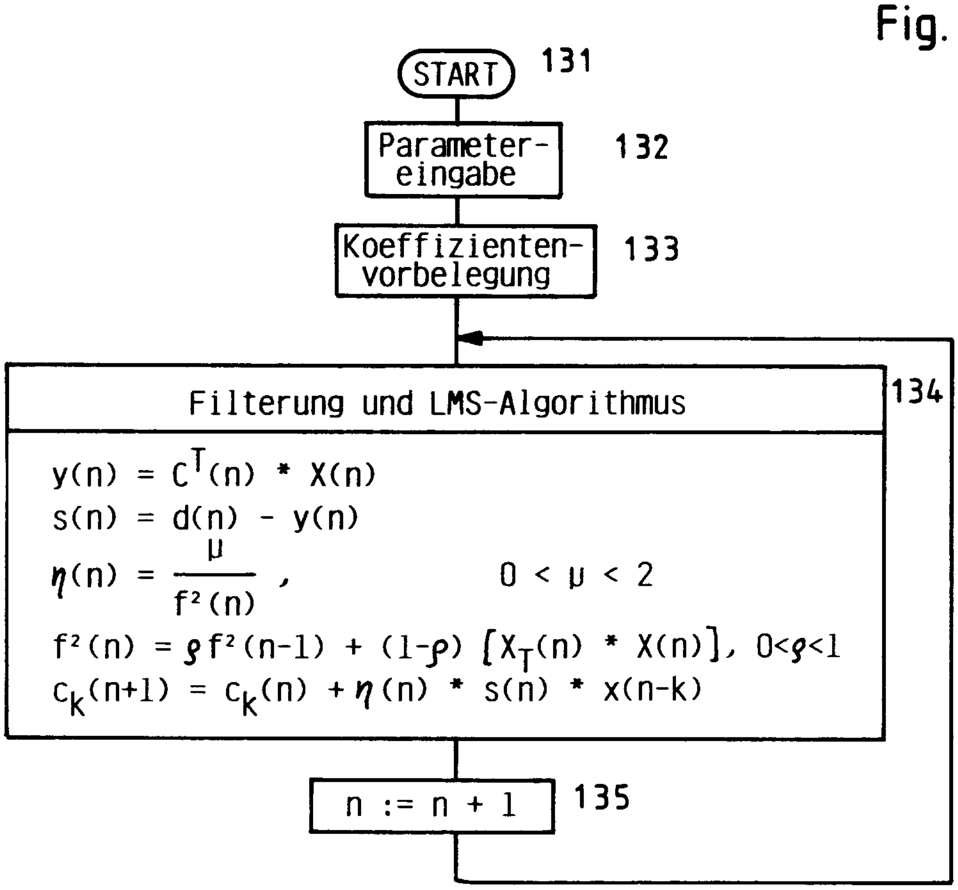
START
131
Parameter-
eingabe
132
Koeffizienten-
vorbelegung
133
Filterung und LMS-Algorithmus
134
$y(n) = C^T(n) * X(n)$
$s(n) = d(n) - y(n)$
$\eta(n) = \frac{\mu}{f^2(n)}$ , $0 < \mu < 2$
$f^2(n) = \varrho f^2(n-1) + (1-\rho) [X_T(n) * X(n)]$, $0<\varrho<1$
$c_k(n+1) = c_k(n) + \eta(n) * s(n) * x(n-k)$
n := n + 1
135

Fig. 6